(19) **Europäisches Patentamt**
**European Patent Office**
**Office européen des brevets**

(11) **EP 2 863 242 A2**

(12) **EUROPEAN PATENT APPLICATION**

(43) Date of publication:
**22.04.2015  Bulletin 2015/17**

(51) Int Cl.:
***G01V 1/30*** (2006.01)

(21) Application number: **14189536.7**

(22) Date of filing: **20.10.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **18.10.2013  US 201361892926 P**

(71) Applicants:
• **Services Petroliers Schlumberger**
 **75007 Paris (FR)**
 Designated Contracting States:
 **FR**
• **Logined B.V.**
 **2586 BJ S Gravenhage (NL)**
 Designated Contracting States:
 **AL AT BE BG CH CY CZ DE DK EE ES FI GB GR HR HU IE IS IT LI LT LU LV MC MK MT NL NO PL PT RO RS SE SI SK SM TR**

(72) Inventors:
• **Bratberg, Ivar**
 **1165 Oslo (NO)**
• **Lusth, Andreas**
 **0353 Oslo (NO)**
• **Wallet, Bradley Clark**
 **4014 Stavanger (NO)**
• **Courtade, Sergio Fabio**
 **1389 Heggedal (NO)**

(74) Representative: **Li, Boxi et al**
 **Schlumberger Cambridge Research Limited**
 **Intellectual Property Law**
 **High Cross**
 **Madingley Road**
 **Cambridge CB3 0EL (GB)**

(54) **Classification and visualization of time-series data**

(57)    Methods, systems, and computer-readable media for processing seismic data. The method includes receiving seismic traces representing a three-dimensional physical domain (602), and determining a partition of a similarity matrix based on a subset of the seismic traces (604). The method also includes determining a transition matrix based on the partition (608). The method also includes determining one or more eigenvectors and one or more eigenvalues (614), based on the transition matrix. The method includes calculating one or more approximated eigenvectors (620) for the similarity matrix, based on the partition, the one or more eigenvectors of the transition matrix, and the one or more eigenvalues of the transition matrix. The method includes assigning visual indicator values (622) to the respective seismic traces based on the one or more approximated eigenvectors, and causing a visualization of the three-dimensional physical domain to be displayed in a two-dimensional view (624), based on the one or more visual indicator values.

FIG 6

**Description**

**Related Applications**

This application claims the benefit of U.S. Provisional Patent Application Serial No. 61/892,926 filed October 18, 2013, which is incorporated herein by reference in its entirety.

**Background**

Seismic interpretation is the process by which recorded seismic traces are employed to determine the characteristics of a subterranean volume. Seismic traces may be acquired using geophones positioned at different locations around a seismic source, which may be an explosion. The explosion may generate seismic waves that propagate through the earth. Some of the waves may proceed downward, until reflected by a reflector such as an interface between two types of rocks. The reflected waves may then proceed back to the surface, e.g., at a horizontal distance from the source. The geophones may measure the arrival of the seismic waves, and may produce one or more seismic traces therefrom.
The seismic traces may be arranged into a seismic cube (e.g., three dimensional), which may represent the subterranean area through which the seismic waves propagate. Various seismic attributes may then be calculated, such as time, amplitude, frequency, attenuation, or more complicated attributes derived therefrom. Some attributes may be calculated prior to arranging the seismic traces. The attributes may be employed and/or visualized to facilitate interpretation of the seismic data, e.g., by enhancing features in the seismic data that might otherwise be difficult to notice.
The visualization of some attributes may be three-dimensional, or may be shown as a series of two-dimensional slices vertically, horizontally, or along a more complex plane. There may be instances where a two-dimensional representation of a three-dimensional volume would be helpful, e.g., to speed up the process of locating certain features in a subterranean volume.

Summary

Embodiments of the disclosure may provide methods, systems, and computer-readable media for processing seismic data. For example, the method may include receiving seismic traces representing a three-dimensional physical domain, and determining a partition of a similarity matrix based at least partially on a subset of the seismic traces. The method may also include determining one or more eigenvectors and one or more eigenvalues, based at least partially on the partition. The method may further include calculating, using a processor, one or more approximated eigenvectors for the similarity matrix, based at least partially on the partition, the one or more eigenvectors of the transition matrix, and the one or more eigenvalues of the transition matrix. The method may additionally include assigning one or more visual indicator values to the respective seismic traces based at least partially on the one or more approximated eigenvectors, and causing a visualization of the three-dimensional physical domain to be displayed in a two-dimensional view, based at least partially on the one or more visual indicator values.

**Brief Description of the Drawings**

The accompanying drawings, which are incorporated in and constitute a part of this specification, illustrate embodiments of the present teachings and together with the description, serve to explain the principles of the present teachings. In the figures:

    Figure 1 illustrates an example system that includes various components for modeling a geologic environment and various equipment associated with the geologic environment, according to an embodiment.
    Figure 2 illustrates a flowchart of a method for processing time-series data, according to an embodiment.
    Figure 3 illustrates a view of a visualization of the time-series data, according to an embodiment.
    Figures 4 and 5 illustrate views of time-series data, according to an embodiment.
    Figure 6 illustrates a flowchart of a method for processing seismic data, according to an embodiment.
    Figure 7 illustrates a schematic view of a computing system, according to an embodiment.

**Detailed Description**

The following detailed description refers to the accompanying drawings. Wherever convenient, the same reference numbers are used in the drawings and the following description to refer to the same or similar parts. While several embodiments and features of the present disclosure are described herein, modifications, adaptations, and other implementations are possible, without departing from the spirit and scope of the present disclosure.

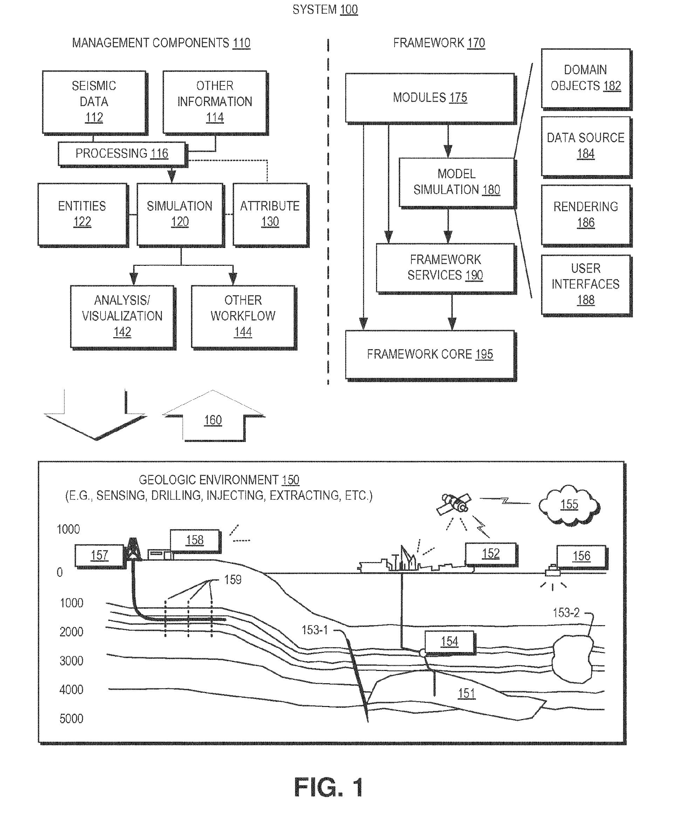

Figure 1 illustrates an example of a system 100 that includes various management components 110 to manage various aspects of a geologic environment 150 (e.g., an environment that includes a sedimentary basin, a reservoir 151, one or more faults 153-1, one or more geobodies 153-2, etc.). For example, the management components 110 may allow for direct or indirect management of sensing, drilling, injecting, extracting, etc., with respect to the geologic environment 150. In turn, further information about the geologic environment 150 may become available as feedback 160 (e.g., optionally as input to one or more of the management components 110).

In the example of Figure 1, the management components 110 include a seismic data component 112, an additional information component 114 (e.g., well/logging data), a processing component 116, a simulation component 120, an attribute component 130, an analysis/visualization component 142 and a workflow component 144. In operation, seismic data and other information provided per the components 112 and 114 may be input to the simulation component 120.

In an example embodiment, the simulation component 120 may rely on entities 122. Entities 122 may include earth entities or geological objects such as wells, surfaces, bodies, reservoirs, etc. In the system 100, the entities 122 can include virtual representations of actual physical entities that are reconstructed for purposes of simulation. The entities 122 may include entities based at least partially on data acquired via sensing, observation, etc. (e.g., the seismic data 112 and other information 114). An entity may be characterized by one or more properties (e.g., a geometrical pillar grid entity of an earth model may be characterized by a porosity property). Such properties may represent one or more measurements (e.g., acquired data), calculations, etc.

In an example embodiment, the simulation component 120 may operate in conjunction with a software framework such as an object-based framework. In such a framework, entities may include entities based at least partially on predefined classes to facilitate modeling and simulation. A commercially available example of an object-based framework is the MICROSOFT® .NET® framework (Redmond, Washington), which provides a set of extensible object classes. In the .NET® framework, an object class encapsulates a module of reusable code and associated data structures. Object classes can be used to instantiate object instances for use in by a program, script, etc. For example, borehole classes may define objects for representing boreholes based at least partially on well data.

In the example of Figure 1, the simulation component 120 may process information to conform to one or more attributes specified by the attribute component 130, which may include a library of attributes. Such processing may occur prior to input to the simulation component 120 (e.g., consider the processing component 116). As an example, the simulation component 120 may perform operations on input information based at least partially on one or more attributes specified by the attribute component 130. In an example embodiment, the simulation component 120 may construct one or more models of the geologic environment 150, which may be relied on to simulate behavior of the geologic environment 150 (e.g., responsive to one or more acts, whether natural or artificial). In the example of Figure 1, the analysis/visualization component 142 may allow for interaction with a model or model-based results (e.g., simulation results, etc.). As an example, output from the simulation component 120 may be input to one or more other workflows, as indicated by a workflow component 144.

As an example, the simulation component 120 may include one or more features of a simulator such as the ECLIPSE™ reservoir simulator (Schlumberger Limited, Houston Texas), the INTERSECT™ reservoir simulator (Schlumberger Limited, Houston Texas), etc. As an example, a simulation component, a simulator, etc. may include features to implement one or more meshless techniques (e.g., to solve one or more equations, etc.). As an example, a reservoir or reservoirs may be simulated with respect to one or more enhanced recovery techniques (e.g., consider a thermal process such as SAGD, etc.).

In an example embodiment, the management components 110 may include features of a commercially available framework such as the PETREL® seismic to simulation software framework (Schlumberger Limited, Houston, Texas). The PETREL® framework provides components that allow for optimization of exploration and development operations. The PETREL® framework includes seismic to simulation software components that can output information for use in increasing reservoir performance, for example, by improving asset team productivity. Through use of such a framework, various professionals (e.g., geophysicists, geologists, and reservoir engineers) can develop collaborative workflows and integrate operations to streamline processes. Such a framework may be considered an application and may be considered a data-driven application (e.g., where data is input for purposes of modeling, simulating, etc.).

In an example embodiment, various aspects of the management components 110 may include add-ons or plug-ins that operate according to specifications of a framework environment. For example, a commercially available framework environment marketed as the OCEAN® framework environment (Schlumberger Limited, Houston, Texas) allows for integration of add-ons (or plug-ins) into a PETREL® framework workflow. The OCEAN® framework environment leverages .NET® tools (Microsoft Corporation, Redmond, Washington) and offers stable, user-friendly interfaces for efficient development. In an example embodiment, various components may be implemented as add-ons (or plug-ins) that conform to and operate according to specifications of a framework environment (e.g., according to application programming interface (API) specifications, etc.).

Figure 1 also shows an example of a framework 170 that includes a model simulation layer 180 along with a framework services layer 190, a framework core layer 195 and a modules layer 175. The framework 170 may include the commercially available OCEAN® framework where the model simulation layer 180 is the commercially available PETREL® model-centric software package that hosts OCEAN® framework applications. In an example embodiment, the PETREL® software may be considered a data-driven application. The PETREL® software can include a framework for model building and visualization.

As an example, a framework may include features for implementing one or more mesh generation techniques. For example, a framework may include an input component for receipt of information from interpretation of seismic data, one or more attributes based at least in part on seismic data, log data, image data, etc. Such a framework may include a mesh generation component that processes input information, optionally in conjunction with other information, to generate a mesh.

In the example of Figure 1, the model simulation layer 180 may provide domain objects 182, act as a data source 184, provide for rendering 186 and provide for various user interfaces 188. Rendering 186 may provide a graphical environment in which applications can display their data while the user interfaces 188 may provide a common look and feel for application user interface components.

As an example, the domain objects 182 can include entity objects, property objects and optionally other objects. Entity objects may be used to geometrically represent wells, surfaces, bodies, reservoirs, etc., while property objects may be used to provide property values as well as data versions and display parameters. For example, an entity object may represent a well where a property object provides log information as well as version information and display information (e.g., to display the well as part of a model).

In the example of Figure 1, data may be stored in one or more data sources (or data stores, generally physical data storage devices), which may be at the same or different physical sites and accessible via one or more networks. The model simulation layer 180 may be configured to model projects. As such, a particular project may be stored where stored project information may include inputs, models, results and cases. Thus, upon completion of a modeling session, a user may store a project. At a later time, the project can be accessed and restored using the model simulation layer 180, which can recreate instances of the relevant domain objects.

In the example of Figure 1, the geologic environment 150 may include layers (e.g., stratification) that include a reservoir 151 and one or more other features such as the fault 153-1, the geobody 153-2, etc. As an example, the geologic environment 150 may be outfitted with any of a variety of sensors, detectors, actuators, etc. For example, equipment 152 may include communication circuitry to receive and to transmit information with respect to one or more networks 155. Such information may include information associated with downhole equipment 154, which may be equipment to acquire information, to assist with resource recovery, etc. Other equipment 156 may be located remote from a well site and include sensing, detecting, emitting or other circuitry. Such equipment may include storage and communication circuitry to store and to communicate data, instructions, etc. As an example, one or more satellites may be provided for purposes of communications, data acquisition, etc. For example, Figure 1 shows a satellite in communication with the network 155 that may be configured for communications, noting that the satellite may additionally or alternatively include circuitry for imagery (e.g., spatial, spectral, temporal, radiometric, etc.).

Figure 1 also shows the geologic environment 150 as optionally including equipment 157 and 158 associated with a well that includes a substantially horizontal portion that may intersect with one or more fractures 159. For example, consider a well in a shale formation that may include natural fractures, artificial fractures (e.g., hydraulic fractures) or a combination of natural and artificial fractures. As an example, a well may be drilled for a reservoir that is laterally extensive. In such an example, lateral variations in properties, stresses, etc. may exist where an assessment of such variations may assist with planning, operations, etc. to develop a laterally extensive reservoir (e.g., via fracturing, injecting, extracting, etc.). As an example, the equipment 157 and/or 158 may include components, a system, systems, etc. for fracturing, seismic sensing, analysis of seismic data, assessment of one or more fractures, etc.

As mentioned, the system 100 may be used to perform one or more workflows. A workflow may be a process that includes a number of worksteps. A workstep may operate on data, for example, to create new data, to update existing data, etc. As an example, a may operate on one or more inputs and create one or more results, for example, based at least partially on one or more algorithms. As an example, a system may include a workflow editor for creation, editing, executing, etc. of a workflow. In such an example, the workflow editor may provide for selection of one or more pre-defined worksteps, one or more customized worksteps, etc. As an example, a workflow may be a workflow implementable in the PETREL® software, for example, that operates on seismic data, seismic attribute(s), etc. As an example, a workflow may be a process implementable in the OCEAN® framework. As an example, a workflow may include one or more worksteps that access a module such as a plug-in (e.g., external executable code, etc.).

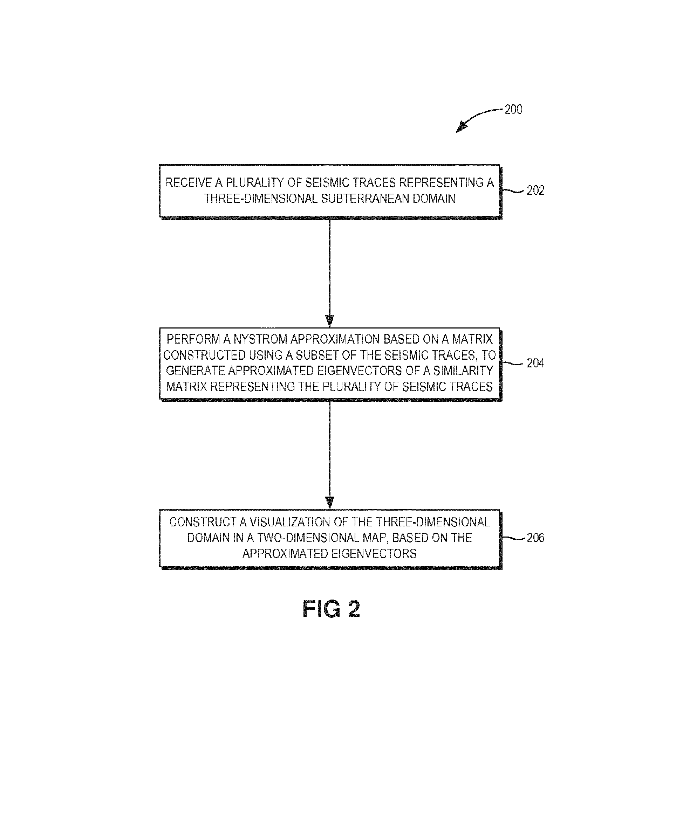

Figure 2 illustrates a flowchart of a method 200 for classifying and visualizing time-series data, according to an embodiment. In some embodiments, the method 200 may be tailored for use in seismic data processing, and is described herein in this context. However, it will be appreciated that the type of data with which this method 200 may be employed is not limited to seismic. Rather, the method 200 may also be readily applied to other contexts in which time-series data is interpreted, such as radiology, the stock market (e.g., share prices), well logs, etc.

Referring to the illustrated example embodiment, the method 200 may include receiving data representing a plurality of seismic traces, which may represent a physical, e.g., subterranean, domain, as at 202. For example, the method 200 may include receiving several (e.g., thousands or more) seismic waveforms or "traces" recorded from channels of geophones located at various positions near a seismic source. The seismic traces may each include several (e.g., thousands or more) data points. For example, the amplitude, phase, frequency, time, or another attribute of the seismic traces may be recorded as the data points.

Furthermore, the seismic volume may be flattened prior to receiving the traces as part of the method 200. For example, to flatten the seismic volume, the index of the trace values may be adjusted such that geological layers are represented as horizontal, thereby removing curves. By removing curves, the method 200 may avoid considering different geological ages in the corresponding indices of different traces.

The method 200 may proceed to performing a Nyström approximation based at least partially on a matrix constructed using a subset of the seismic traces, as at 206. This may result in the method 200 generating approximated eigenvectors of a similarity matrix that represents the plurality of seismic traces. The similarity matrix, if it were constructed, might be large, and thus storing and performing operations thereon might be memory and/or computationally intensive. Accordingly, in at least one embodiment, the similarity matrix itself might not be constructed. However, landmarks or samples of the seismic traces may be selected, and from that sampling, a transition matrix may be constructed. Thus, following the Nyström approximation method, as will be described below according to an example embodiment, the method 200 may approximate the similarity matrix and calculate approximated eigenvectors therefrom.

The method 200 may then proceed to constructing a visualization of the three-dimensional domain in a two-dimensional map, based at least partially on the approximated eigenvectors, as at 208. In other examples, the visualization may have other numbers of dimensions. In an embodiment, values of visual indicators for the seismic traces may be selected from each (or a subset) of the approximated eigenvectors. For example, the $i$-th element of each (or a subset) of the approximated eigenvectors may be assigned as a visual indicator for an associated seismic trace. The seismic traces may then be plotted in a "feature space" based at least partially on the values of the visual indicators. It will be appreciated that additional or fewer feature-space dimensions may be readily employed without departing from the scope of the present disclosure.

In the case of a seismic model, for example, the seismic traces may be given a color based at least partially on their respective feature-space coordinates. In an example embodiment, the signal traces may be assigned a red intensity value, a green intensity value, and a blue intensity value, e.g., between 0 and 255 (although any suitable values may be used), based at least partially on the values of the associated indices in the three eigenvectors (e.g., defining the feature space coordinates). A color may thus be determined for the signal trace based at least partially on the assigned intensities.

The seismic traces may then be mapped into a two-dimensional view. The traces may have a location in a given $x$-$y$ plane of a seismic cube (e.g., a location at a given depth or horizontal plane, which may or may not be the Earth's surface). The locations representing the seismic traces may then be colored using the assigned colors for the respective traces. Similar seismic traces (e.g., with similar time-series data) may appear similar in color, which may serve to enhance or otherwise more clearly draw attention to various objects of interest in the domain.

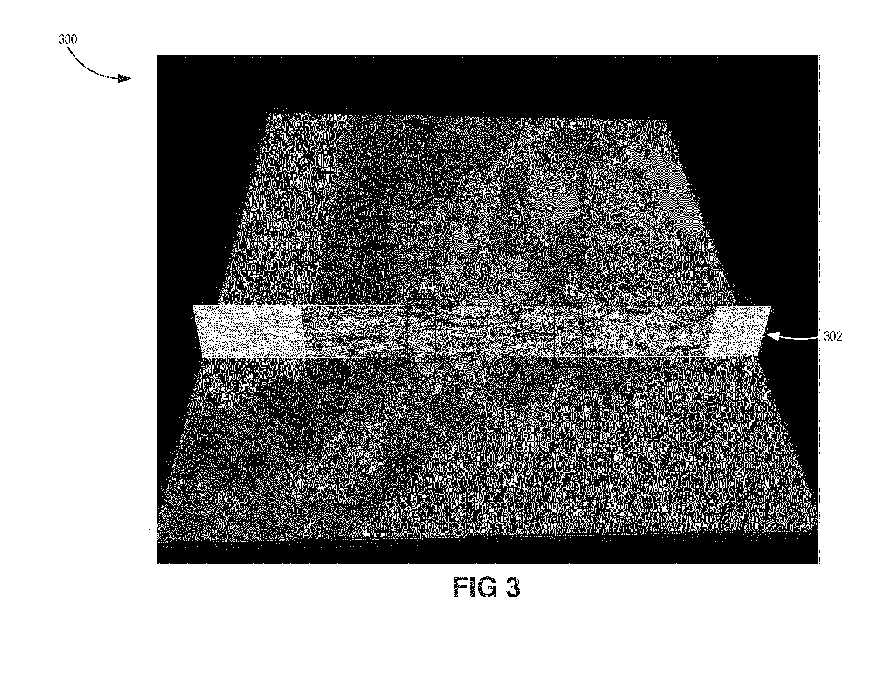

Figure 3 illustrates a perspective view of a visualization 300 of a three-dimensional domain, according to an embodiment. The visualization 300 may be generated using one or more embodiments of the method 200, for example. Furthermore, for purposes of illustration, a vertical slice 302 is depicted in the visualization 300, although it will be appreciated that the vertical slide 302 may or may not be a part of the visualization 300.

The levels of gray in Figure 3 are generally representative of color differences, such as assigned using the visual indicator values, for example. Any number of colors may be employed. Similar colors may represent seismic traces of similar characteristics. Thus, the visualization 300 may yield a quick way to pick areas of interest, e.g., for further analysis.

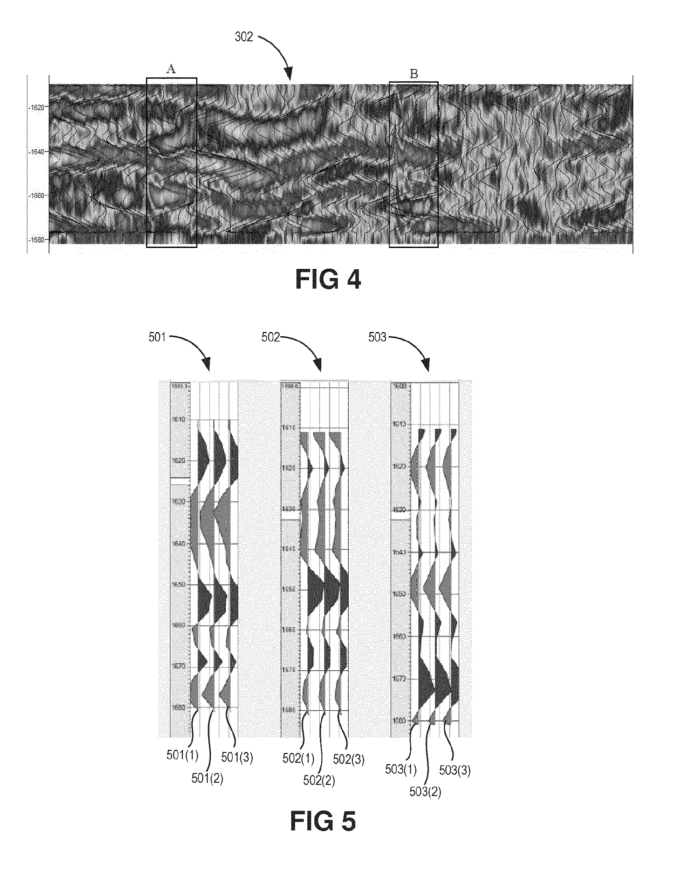

With continuing reference to Figure 3, Figure 4 illustrates a clearer view of the vertical slice 302, according to an embodiment. As can be appreciated, the seismic traces in the region labeled 'A' are generally similar to one another. As such, the areas represented by these traces in the visualization 300 of Figure 3 may have similar colors assigned to them. The traces in the region labeled 'B' in the slice 302 are also similar to one another, but are different from the traces of region A. Accordingly, the areas represented by the traces in region B in the visualization 200 may have a similar color, which is different from the range of colors assigned to the traces in region A.

Figure 5 illustrates seismic data from three example wells 501, 502, 503, according to an embodiment. As shown, each of the wells 501-503 may include three (or any other number of) time series 501(1)-(3), 502(1)-(3), and 503(1)-(3), respectively. These time series 501(1)-(3), 502(1)-(3), and 503(1)-(3) may be seismic traces, but in other embodiments, may be other time series that may be collected in a wellbore. As can be seen in Figure 5, the time series 501(1)-(3) are similar to one another, and thus, in a visualization (e.g., the visualization 200) including the well 501, these time series 501(1)-(3) may have a similar color assigned thereto. Further, the waveforms of the time series 501(1)-(3) are similar in shape to the waveforms of the traces 502(1)-(3) from the second well 502. Thus, a similar color may be assigned to these traces 502(1)-(3) as well. The waveforms of the time series 503(1)-(3) from the third well 503 may be different, however, from the other traces 501(1)-(3), 502(1)-(3), and thus may be assigned a contrasting color. The colors may thus provide a quick way to determine the relative shape of the waveforms, which may assist in identifying regions of interest for further study.

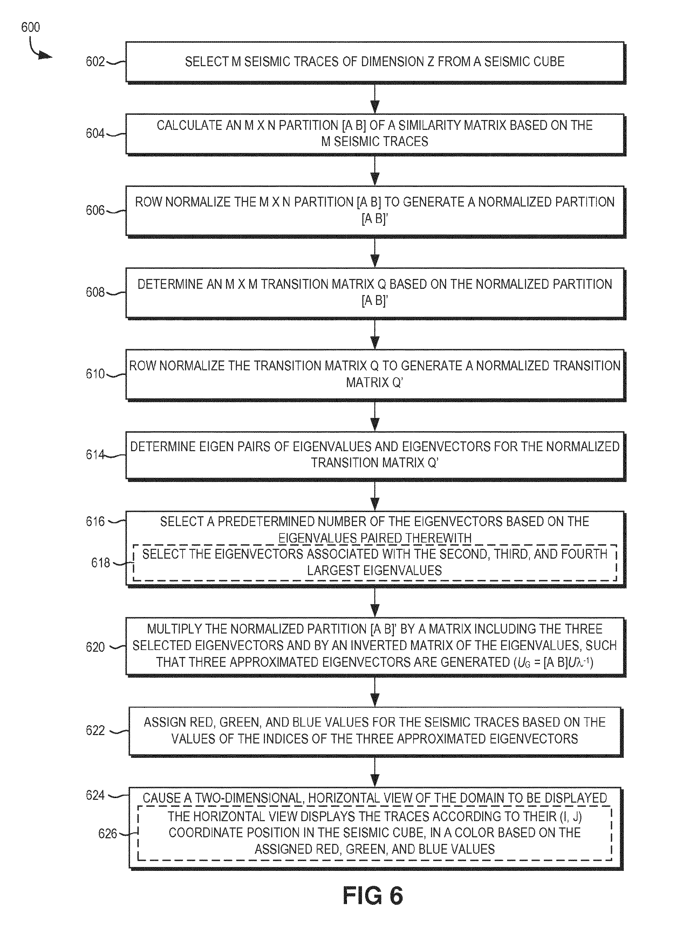

Figure 6 illustrates a flowchart of a method 600 for processing time-series data, according to an embodiment. Here again, the time-series data is described in terms of seismic traces; however, it will be appreciated that other types of data may be employed without departing from the scope of the present disclosure.

The method 600 may begin with a set of N seismic traces, e.g., as included in a seismic cube. The seismic traces may each be vectors (or any other data structure) of numbers, e.g., floating point numbers, with each number defining a dimension of the trace. The traces may each have Z dimensions. Moreover, the traces may correspond to a horizontal location in the seismic cube, located at coordinates (i,j).

In some embodiments, rather than attempting to store a matrix of similarity values for the full set of seismic traces, the method 600 may include selecting a subset of the seismic traces from the seismic cube, as at 602. The subset may contain M seismic traces, with M being less than N.

The method 600 may then calculate an M x N partition [A B] of a similarity matrix $K$, based at least partially on the selected, M seismic traces, as at 604. Again, the full similarity matrix may not be calculated, so as to conserve time, computing power, and/or memory. The partition [A B] may include a row for each of the M seismic traces, and a column for each of the N seismic traces. The values of each element [A B]$i_{,j}$ of the partition [A B] may represent a value based at least partially on a similarity between the i-th trace and the j-th trace.

In various embodiments, the picking of M seismic traces from the N seismic traces for the M rows of the partition [A B] may be performed by selecting the traces uniformly at random, using a Metropolis algorithm, using a kernel k-mean clustering, or using any other suitable picking process. Accordingly, the partition [A B] may be populated by "landmark" seismic traces from the seismic cube.

To calculate the similarity values that populate the partition [A B], a similarity calculation algorithm may be used. Although any suitable similarity calculation algorithm may be used, one example of such a similarity calculation algorithm may include calculating a Pearson correlation. The Pearson correlation may be defined between two vectors (in this example, traces) x and y as:

$$p_{x,y} = \frac{\text{cov}(x,y)}{\sigma_x \sigma_y} \qquad (1)$$

where cov(x,y) is the covariance, and $\sigma$ is the standard deviation. The elements of the similarity *matrix K* (or, when the full similarity matrix $K$ is not computed, the elements of the partition [A B]) may, in turn, be calculated as $K_{i,j} = \exp(\rho_{i,j} -1)$. In other embodiments, other measurements and/or claculations may be employed to populate the similarity matrix $K$.

In some embodiments, to compensate for non-perfect flattening of the seismic volume, a maximum correlation between two traces may be determined using an offset. The offset may be varied from 0 to some number h. In some embodiments, the number h may be between 0 and 4, inclusive. Thus, the maximum correlation of a volume represented by the indexes [a-b] of the entire trace array may be found according to the following description:

```
LET S be a seismic trace consisting of a vector of float values, the elements are indexed from 0 to L (length of vector L-1)
LET T be another seismic trace consisting of a vector of float values, the elements are indexed from 0 to L (length of vector L-1)
LET i = the index into S and T which corresponds to the top of the seismic volume we want to study
LET j = the index into S and T which corresponds to the bottom of the seismic volume we want to study
LET MAXCOR = -Inf
FOR G in [0,1,2,3,4] { MAXCOR = MAXIMUM(MAXCOR,cor(T[i+g:j+g], S[i:j]), cor(S[i+g:j+g], T[i:j]))
} // MAXCOR is then the result for the two traces S and T.
```

In an embodiment, the method 600 may include row-normalizing the partition [A B], such that a normalized partition [A B]' is generated, as at 606. The method 600 may then proceed to determining a "transition" matrix $Q$ based at least partially on the similarity matrix partition [A B] (e.g., in its normalized form [A B]'), as at 608. The transition matrix $Q$ may be a square matrix of M x M dimensions, as indicated at 612, representing the similarities between the M seismic traces.

The M seismic traces may be selected from the total, N seismic traces, represented in the N columns of the partition [A B]' using any suitable picking algorithm, similar to the way in which the M seismic traces were selected for the rows of the partition [A B]. The transition matrix Q may then be row-normalized, as at 610, so as to generate a normalized transition matrix $Q'$.

The method 100 may then include performing a spectral decomposition of the transition matrix $Q'$, so as to determine at least some of the eigen pairs (eigenvalues and eigenvectors) of the transition matrix $Q'$, as at 614. In some embodiments, the method 600 may include calculating the full set of eigen pairs for the transition matrix $Q'$, but in others, may calculate a subset thereof.

The method 600 may also include selecting a predetermined number of the eigenvectors based at least partially on the eigenvalues associated therewith, as at 616. Specifically, in this example, the illustrated embodiment includes selecting the second, third, and fourth largest eigenvectors, e.g., as calculated using the transition matrix $Q'$, as indicated at 618. The selection of three eigenvectors, and these three in particular, is but one example among many contemplated. If, for example, more or less than three dimensions are to be used to classify the seismic trace (see below), more or less than three eigenvectors may be selected. Furthermore, the first, second, and third largest eigenvectors may be selected, or the third, fourth, and fifth, or any other set, of eigenvectors may be selected, without limitation.

The method 600 may also include multiplying the partition [A B] by a matrix that includes the three selected eigenvectors and then by an inverted matrix containing the eigenvalues, such that three approximated eigenvectors are determined, as at 620. As noted above, the partition [A B] may be an N x M matrix. The three (in this example) eigenvectors may be used to form a matrix $U$, which may have dimensions M x 3. In some embodiments, the matrix U may have a number of columns other than three, e.g., depending on the number of dimensions in feature space in which the seismic traces are to be plotted, as will be described below. Three columns are used herein for purposes of description, but this is not to be considered limiting unless otherwise expressly stated.

Accordingly, the product of the partition [A B] (N x M dimensions) and the matrix $U$ (M x 3 dimensions) may be an N x 3 "product" matrix. Further, the eigenvalues may be formed into a fourth matrix and inverted, yielding, for example, a 3 x 3 matrix (or another dimension size, depending on the number of eigenvectors selected). Thus, the product of the N x 3 product matrix and the 3 x 3 inverted eigenvalue matrix $\lambda^{-1}$ may be a matrix $U_Q$ of dimensions N x 3. The matrix $U_Q$ may be an approximation (e.g., according to a Nyström approximation method) of three eigenvectors of the full, normalized similarity matrix K. This operation may be expressed as:

$$U_Q = [A\ B]U\lambda^{-1} \qquad (2)$$

The method 600 may include assigning feature coordinates to the seismic traces, based at least partially on the approximated eigenvectors. In the example herein, the seismic traces are plotted in three dimensions, as this may be convenient for assigning a color. However, other numbers of dimensions are contemplated.

In the illustrated example, at 622, the method 600 may include, for one or more traces $i$, selecting the values contained in the $i$-th row of the matrix that includes the approximated eigenvectors. In other words, three values, one from each of the approximated eigenvectors may be selected. These values may be normalized into an intensity spectrum, e.g., between a value of 0 and 255, according to an embodiment, with the respective values being assigned to a color, e.g., red, green, or blue. The combination of the three intensity values may thus correspond to a color with the associated three intensity values.

The method 600 may also include displaying a two-dimensional horizontal or "map" view of the seismic traces, as at 624. The horizontal view may be similar to the visualization 300 illustrated in Figure 3. In the two-dimensional, horizontal view, the traces may be displayed by color, e.g., the color resulting from the assigned red, green, and blue values, such that the color represents the three dimensions (i.e., selected values form the approximated eigenvectors) of the seismic cube, as indicated at 626. For example, the color may provide a shorthand representation of the shape of the waveform, relative to the shape of the other waveforms (seismic traces) in the seismic cube. Further, the similarity of the colors may indicate that certain features (e.g., basins, domes, traps, faults, etc.) are present in a given region. As such, further investigation may be focused on this (or these) volume(s) of the cube.

In addition, in some embodiments, once the visualization is constructed and displayed at 624, or at any other time, the method 600 may return to selecting a new value for M, and then selecting the M traces, as at 606. For example, the new selected value for M may be larger than the value previously selected. The method 600 may then proceed through the aforementioned blocks 606-622, thereby determining a new transition (second) matrix, and using the new transition matrix to determine new approximated eigenvectors, and thus new visual indicator values for the seismic traces. Once returning to block 624, the method 600 may update the visualization with the new visual indicator values. Thus, the method 600 may, one or more (e.g., several) times, construct the two-dimensional display using larger and larger numbers for M. As such, with each update, the estimation provided by the Nyström approximation may have an enhanced accuracy, as the number of landmark traces approaches the total number of traces.

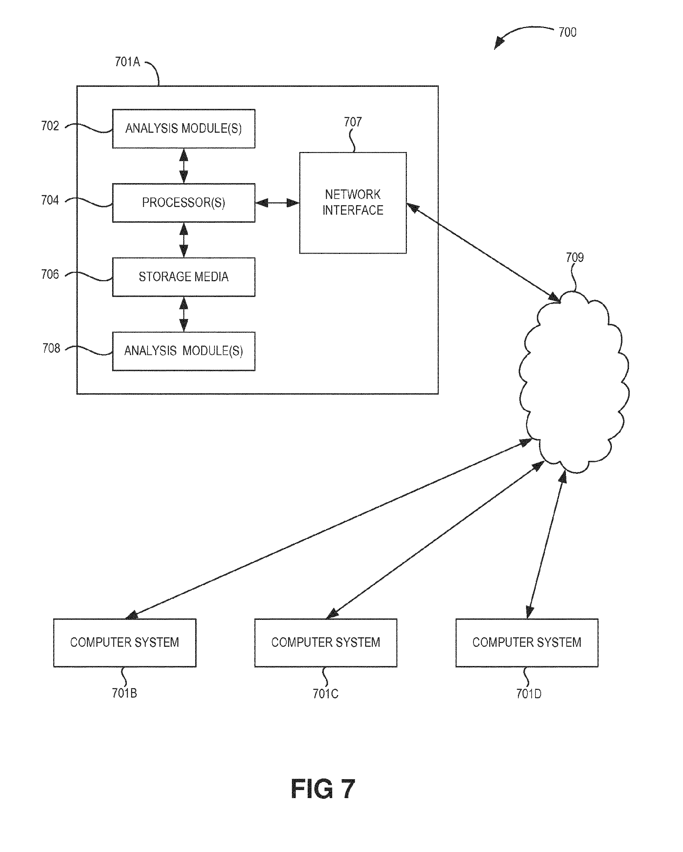

In some embodiments, the methods 200, 600 (and/or any of the processes thereof) may be executed by a computing system. Figure 7 illustrates an example of such a computing system 700, in accordance with some embodiments. The computing system 700 may include a computer or computer system 701A, which may be an individual computer system 701A or an arrangement of distributed computer systems. The computer system 701A includes one or more analysis modules 702 that are configured to perform various tasks according to some embodiments, such as one or more methods disclosed herein (e.g., methods 200, 600, and/or combinations and/or variations thereof). To perform these various tasks, the analysis module 702 executes independently, or in coordination with, one or more processors 704, which is (or are) connected to one or more storage media 706A. The processor(s) 704 is (or are) also connected to a network interface 707 to allow the computer system 701A to communicate over a data network 709 with one or more additional computer systems and/or computing systems, such as computing systems 701B, 701C, and/or 701D (note that computer systems 701B, 701C, and/or 701D may or may not share the same architecture as computer system 701A, and may be located in different physical locations, e.g., computer systems 701A and 701B may be located in a processing facility, while in communication with one or more computer systems such as 701 C and/or 701D that are located in one or more data centers, and/or located in varying countries on different continents).

A processor can include a microprocessor, microcontroller, processor module or subsystem, programmable integrated circuit, programmable gate array, or another control or computing device.

The storage media 706A can be implemented as one or more computer-readable or machine-readable storage media. Note that while in the example embodiment of Figure 7 storage media 706A is depicted as within computer system 701A, in some embodiments, storage media 706A may be distributed within and/or across multiple internal and/or external enclosures of computing system 701A and/or additional computing systems. Storage media 706A may include one or more different forms of memory including semiconductor memory devices such as dynamic or static random access memories (DRAMs or SRAMs), erasable and programmable read-only memories (EPROMs), electrically erasable and programmable read-only memories (EEPROMs) and flash memories, magnetic disks such as fixed, floppy and removable disks, other magnetic media including tape, optical media such as compact disks (CDs) or digital video disks (DVDs), BLUERAY® disks, or other types of optical storage, or other types of storage devices. Note that the instructions discussed above can be provided on one computer-readable or machine-readable storage medium, or alternatively, can be provided on multiple computer-readable or machine-readable storage media distributed in a large system having possibly plural nodes. Such computer-readable or machine-readable storage medium or media is (are) considered to be part of an article (or article of manufacture). An article or article of manufacture can refer to any manufactured single component or multiple components. The storage medium or media can be located either in the machine running the machine-readable instructions, or located at a remote site from which machine-readable instructions can be downloaded over a network for execution.

In some embodiments, computing system 700 contains one or more modeling module(s) 708. In the example of computing system 700, computer system 701A includes a modeling module 708. In some embodiments, a single modeling module may be used to perform some or all aspects of one or more embodiments of the method 200, 600. In alternate embodiments, a plurality of modeling modules may be used to perform some or all aspects of method 200, 600.

It should be appreciated that computing system 700 is only one example of a computing system, and that computing system 700 may have more or fewer components than shown, may combine additional components not depicted in the example embodiment of Figure 7, and/or computing system 700 may have a different configuration or arrangement of the components depicted in Figure 7. The various components shown in Figure 7 may be implemented in hardware, software, or a combination of both hardware and software, including one or more signal processing and/or application specific integrated circuits.

Further, the various aspects of the processing methods described herein may be implemented by running one or more functional modules in information processing apparatus such as general purpose processors or application specific chips, such as ASICs, FPGAs, PLDs, or other appropriate devices. These modules, combinations of these modules, and/or their combination with general hardware are all included within the scope of protection of the invention.

The various aspects of the processing methods described herein may be implemented by running one or more functional modules in information processing apparatus such as general purpose processors or application specific chips, such as ASICs, FPGAs, PLDs, or other appropriate devices. These modules, combinations of these modules, and/or their combination with general hardware are all included within the scope of protection of the invention.

Moreover, geologic interpretations, models and/or other interpretation aids may be refined in an iterative fashion; this concept is applicable to the method 200, 600 as discussed herein. This can include use of feedback loops executed on an algorithmic basis, such as at a computing device (e.g., computing system 700, Figure 7), and/or through manual control by a user who may make determinations regarding whether a given step, action, template, model, or set of curves has become sufficiently accurate for the evaluation of the subsurface three-dimensional geologic formation under consideration.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated.

**Claims**

1. A computer-implemented method for processing seismic data, comprising:

   receiving seismic traces representing a three-dimensional physical domain;
   determining a partition of a similarity matrix based at least partially on a subset of the seismic traces;
   determining one or more eigenvectors and one or more eigenvalues, based at least partially on the partition;
   calculating, using a processor, one or more approximated eigenvectors for the similarity matrix, based at least partially on the partition, the one or more eigenvectors, and the one or more eigenvalues;
   assigning one or more visual indicator values to the respective seismic traces based at least partially on the one or more approximated eigenvectors; and
   causing a visualization of the three-dimensional physical domain to be displayed in a two-dimensional view, based at least partially on the one or more visual indicator values.

2. The method of claim 1, wherein determining the one or more eigenvectors and the one or more eigenvalues comprises:

   determining a square transition matrix based at least partially on the partition; and
   performing a spectral decomposition of the transition matrix.

3. The method of claim 2, wherein determining the transition matrix comprises:

   selecting a number M of the seismic traces, wherein a total number of the seismic traces is a number N, N being larger than M; and
   selecting values from the partition, such that the transition matrix has a dimension of M x M.

4. The method of any preceding claim, further comprising constructing the visualization comprising:

   associating areas of the two-dimensional view with the seismic traces; and
   determining colors for the areas of the two-dimensional view based at least partially on the one or more visual indicator values assigned to the respective seismic traces.

5. The method of any preceding claim, further comprising row normalizing values of the partition prior to determining the one or more eigenvectors and the one or more eigenvalues.

6. The method of any preceding claim, wherein calculating the one or more approximated eigenvectors for the similarity matrix comprises:

   defining a matrix $U$, wherein one or more columns of the matrix $U$ each comprise one of the one or more eigenvectors;
   defining a matrix $\lambda$ based at least partially on the one or more eigenvalues;
   multiplying the partition by the matrix U to generate a product;
   inverting the matrix $\lambda$ to generate an inverted matrix; and
   multiplying the product by the inverted matrix, such that a matrix $U_Q$ is generated, wherein respective columns of the matrix $U_Q$ comprise one of the plurality of approximated eigenvectors.

7. The method of any preceding claim, calculating the one or more eigenvalues and the one or more eigenvectors comprises selecting a predetermined number of eigenvectors from among a plurality of eigenvectors calculated for the second matrix, based at least partially on eigenvalues associated with the plurality of eigenvectors.

8. The method of any preceding claim, wherein assigning the one or more respective visual indicator values to the respective seismic traces based at least partially on the one or more approximated eigenvectors comprises:

determining a value of an *i*-th element of the one or more approximated eigenvectors; and
assigning at least one of the one or more visual indicator values to the *i*-th one of the seismic traces based at least partially on the *i*-th element of the one or more approximated eigenvectors.

9. The method of any preceding claim, further comprising, after causing the visualization to be displayed:

selecting a new set of seismic traces from the plurality of seismic traces of the seismic cube, wherein the new set is larger than the subset of traces previously selected;
determining a new transition matrix based at least partially on the new set of seismic traces;
calculating a new set of one or more approximated eigenvectors for the similarity matrix based at least partially on the new transition matrix;
assigning one or more new visual indicator values to at least one of the seismic traces based at least partially on the new set of one or more approximated eigenvectors; and
updating the visualization based at least partially on the one or more new visual indicator values.

10. A non-transitory computer-readable medium storing instructions that, when executed by one or more processors of a computing system, cause the computing system to perform operations, the operations comprising:

receiving seismic traces representing a three-dimensional physical domain;
determining a partition of a similarity matrix based at least partially on a subset of the seismic traces;
determining one or more eigenvectors and one or more eigenvalues, based at least partially on the transition matrix;
calculating one or more approximated eigenvectors for the similarity matrix, based at least partially on the partition, the one or more eigenvectors of the transition matrix, and the one or more eigenvalues of the transition matrix;
assigning one or more visual indicator values to the respective seismic traces based at least partially on the one or more approximated eigenvectors; and
causing a visualization of the three-dimensional physical domain to be displayed in a two-dimensional view, based at least partially on the one or more visual indicator values.

11. The medium of claim 10, wherein the operations further comprise constructing the visualization comprising:

associating areas of the two-dimensional view with the seismic traces; and
determining colors for the areas of the two-dimensional view based at least partially on the one or more visual indicator values assigned to the respective seismic traces.

12. The medium of claim 10 or claim 11, wherein the operations further comprise row normalizing values of the partition prior to determining the transition matrix.

13. The medium of any of claims 10-12, wherein determining the transition matrix comprises:

selecting a number M of the seismic traces, wherein a total number of the seismic traces is a number N, N being larger than M; and
selecting values from the partition, such that the transition matrix has a dimension of M x M.

14. The medium of any of claims 10-13, wherein calculating the one or more approximated eigenvectors of the first matrix comprises:

defining a matrix $U$, wherein one or more columns of the matrix $U$ each comprise one of the one or more eigenvectors;
defining a matrix $\lambda$ based at least partially on the one or more eigenvalues;
multiplying the partition by the matrix $U$ to generate a product;
inverting the matrix $\lambda$ to generate an inverted matrix; and
multiplying the product by the inverted matrix, such that a matrix $U_Q$ is generated, wherein respective columns of the matrix $U_Q$ comprise one of the plurality of approximated eigenvectors.

15. The medium of any of claims 10-14, calculating the one or more eigenvalues and the one or more eigenvectors comprises selecting a predetermined number of eigenvectors from among a plurality of eigenvectors calculated for the second matrix, based at least partially on eigenvalues associated with the plurality of eigenvectors.

**16.** The medium of any of claims 10-16, wherein assigning the one or more respective visual indicator values to the respective seismic traces based at least partially on the one or more approximated eigenvectors comprises:

determining a value of an $i$-th element of the one or more approximated eigenvectors; and
assigning at least one of the one or more visual indicator values to the $i$-th one of the seismic traces based at least partially on the $i$-th element of the one or more approximated eigenvectors.

**17.** A computing system, comprising:

one or more processors; and
a memory system comprising one or more non-transitory computer-readable media storing instructions that, when executed by at least one of the one or more processors, cause the computing system to perform operations, the operations comprising:

receiving seismic traces representing a three-dimensional physical domain;
determining a partition of a similarity matrix based at least partially on a subset of the seismic traces;
determining a transition matrix based at least partially on the partition, wherein the transition matrix is a square matrix;
determining one or more eigenvectors and one or more eigenvalues, based at least partially on the transition matrix;
calculating one or more approximated eigenvectors for the similarity matrix, based at least partially on the partition, the one or more eigenvectors of the transition matrix, and the one or more eigenvalues of the transition matrix;
assigning one or more visual indicator values to the respective seismic traces based at least partially on the one or more approximated eigenvectors; and
causing a visualization of the three-dimensional physical domain to be displayed in a two-dimensional view, based at least partially on the one or more visual indicator values.

SYSTEM 100

MANAGEMENT COMPONENTS 110

| SEISMIC DATA 112 | OTHER INFORMATION 114 |
|---|---|

PROCESSING 116

| ENTITIES 122 | SIMULATION 120 | ATTRIBUTE 130 |
|---|---|---|

| ANALYSIS/ VISUALIZATION 142 | OTHER WORKFLOW 144 |
|---|---|

FRAMEWORK 170

MODULES 175

MODEL SIMULATION 180

FRAMEWORK SERVICES 190

FRAMEWORK CORE 195

DOMAIN OBJECTS 182

DATA SOURCE 184

RENDERING 186

USER INTERFACES 188

160

GEOLOGIC ENVIRONMENT 150
(E.G., SENSING, DRILLING, INJECTING, EXTRACTING, ETC.)

1000
0
1000
2000
3000
4000
5000

1000

157    158    159    155

152    156

153-2

153-1    154

151

**FIG. 1**

200

RECEIVE A PLURALITY OF SEISMIC TRACES REPRESENTING A THREE-DIMENSIONAL SUBTERRANEAN DOMAIN — 202

PERFORM A NYSTROM APPROXIMATION BASED ON A MATRIX CONSTRUCTED USING A SUBSET OF THE SEISMIC TRACES, TO GENERATE APPROXIMATED EIGENVECTORS OF A SIMILARITY MATRIX REPRESENTING THE PLURALITY OF SEISMIC TRACES — 204

CONSTRUCT A VISUALIZATION OF THE THREE-DIMENSIONAL DOMAIN IN A TWO-DIMENSIONAL MAP, BASED ON THE APPROXIMATED EIGENVECTORS — 206

FIG 2

**FIG 3**

FIG 4

FIG 5

600

602 — SELECT M SEISMIC TRACES OF DIMENSION Z FROM A SEISMIC CUBE

604 — CALCULATE AN M X N PARTITION [A B] OF A SIMILARITY MATRIX BASED ON THE M SEISMIC TRACES

606 — ROW NORMALIZE THE M X N PARTITION [A B] TO GENERATE A NORMALIZED PARTITION [A B]'

608 — DETERMINE AN M X M TRANSITION MATRIX Q BASED ON THE NORMALIZED PARTITION [A B]'

610 — ROW NORMALIZE THE TRANSITION MATRIX Q TO GENERATE A NORMALIZED TRANSITION MATRIX Q'

614 — DETERMINE EIGEN PAIRS OF EIGENVALUES AND EIGENVECTORS FOR THE NORMALIZED TRANSITION MATRIX Q'

616 — SELECT A PREDETERMINED NUMBER OF THE EIGENVECTORS BASED ON THE EIGENVALUES PAIRED THEREWITH
618 — SELECT THE EIGENVECTORS ASSOCIATED WITH THE SECOND, THIRD, AND FOURTH LARGEST EIGENVALUES

620 — MULTIPLY THE NORMALIZED PARTITION [A B]' BY A MATRIX INCLUDING THE THREE SELECTED EIGENVECTORS AND BY AN INVERTED MATRIX OF THE EIGENVALUES, SUCH THAT THREE APPROXIMATED EIGENVECTORS ARE GENERATED ($U_G$ = [A B]$U\lambda^{-1}$)

622 — ASSIGN RED, GREEN, AND BLUE VALUES FOR THE SEISMIC TRACES BASED ON THE VALUES OF THE INDICES OF THE THREE APPROXIMATED EIGENVECTORS

624 — CAUSE A TWO-DIMENSIONAL, HORIZONTAL VIEW OF THE DOMAIN TO BE DISPLAYED
626 — THE HORIZONTAL VIEW DISPLAYS THE TRACES ACCORDING TO THEIR (I, J) COORDINATE POSITION IN THE SEISMIC CUBE, IN A COLOR BASED ON THE ASSIGNED RED, GREEN, AND BLUE VALUES

# FIG 6

EP 2 863 242 A2

FIG 7

**REFERENCES CITED IN THE DESCRIPTION**

**Patent documents cited in the description**

- US 61892926 A